# EUROPEAN PATENT APPLICATION

(11) **EP 4 686 063 A1**
(43) Date of publication of application: **28.01.2026**
(21) Application number: 24822392.7
(22) Date of filing: 19.04.2024
(51) Int. Cl.: H02M 1/14, H02M 3/04, H02M 1/00, H02M 3/00

(54) **FILTER OF DIRECT-CURRENT POWER SOURCE, AND ELECTRIC DRIVE CONTROLLER AND VEHICLE**

(30) Priority: 14.06.2023 CN 202310708072
(71) Applicant: ZHEJIANG ZEEKR INTELLIGENT TECHNOLOGY CO., LTD., Ningbo, Zhejiang 315899 (CN); VIRIDI E-MOBILITY TECHNOLOGY (NINGBO) CO., LTD., Ningbo, Zhejiang 315336 (CN); Zhejiang Geely Holding Group Co., Ltd., Hangzhou, Zhejiang 310051 (CN)
(72) Inventor: LI, Mingfu, Ningbo, Zhejiang 315899 (CN); XU, Xunjin, Ningbo, Zhejiang 315899 (CN); LI, Changluo, Ningbo, Zhejiang 315899 (CN); NIU, Yaqi, Ningbo, Zhejiang 315899 (CN)
(74) Representative: Michalski Hüttermann & Partner Patentanwälte mbB
(86) International application number: PCT/CN2024/088703
(87) International publication number: WO 2024/255437

(57) **Abstract**

Disclosed in the present application are a filter of a direct-current power source, and an electric drive controller and a vehicle. The filter of a direct-current power source comprises a base, a power source charging copper bar, a power source positive copper bar, a power source negative copper bar and at least three stages of filtering assemblies, wherein the power source charging copper bar, the power source positive copper bar, the power source negative copper bar and the at least three stages of filtering assemblies are all assembled on the base, and the at least three stages of filtering assemblies are electrically connected to the power source charging copper bar, the power source positive copper bar and the power source negative copper bar, respectively.

## Description

### CROSS-REFERENCE TO RELATED APPLICATIONS

The present application claims priority to Chinese patent application No. 202310708072.0, filed with the Chana National Intellectual Property Administration on June 14, 2023, which is hereby incorporated by reference in its entirety.

### TECHNICAL FIELD

Embodiments of the present application relate to, but are not limited to, the field of filtering technologies, and in particular, relate to, but are not limited to, a filter of a direct-current power supply, an electric drive controller, and a vehicle.

### BACKGROUND

Driven by the national strategy of carbon peaking and carbon neutrality goals and supported by new energy industrialization, the new energy vehicle has experienced rapid development, especially the 800 V high-voltage and high-power density electric drive controller, represented by the third-generation wide-bandgap silicon carbide (SiC) power semiconductor, has been widely used due to the advantages of high switching frequency, low loss and good temperature resistance.

### SUMMARY

The following is a summary of subject matter described in detail herein. This summary is not intended to limit the scope of the claims. Embodiments of the present application provide a filter of a direct-current power supply that has a simple structure, a compact layout, and a small volume, an electric drive controller, and a vehicle.

An embodiment of the present application provides a filter of a direct-current power supply, including: a base; a power charging copper bar, assembled to the base; a power positive copper bar, assembled to the base; a power negative copper bar, assembled to the base; and at least three stages of filter components, where the at least three stages of filter components are assembled to the base, and are electrically connected to the power charging copper bar, the power positive copper bar, and the power negative copper bar.

In some embodiments, the base extends along a first direction and a second direction that are located in a same horizontal plane and intersect with each other; the power charging copper bar includes a power charging copper bar input terminal and a power charging copper bar output terminal; the power positive copper bar includes a power positive copper bar input terminal and a power positive copper bar output terminal; the power negative copper bar includes a power negative copper bar input terminal and a power negative copper bar output terminal; where the power charging copper bar input terminal, the power positive copper bar input terminal, and the power negative copper bar input terminal extend side by side along the first direction, and where the power charging copper bar output terminal, the power positive copper bar output terminal, and the power negative copper bar output terminal extend side by side along the second direction.

In some embodiments, the power charging copper bar input terminal, the power positive copper bar input terminal and the power negative copper bar input terminal have height differences relative to the horizontal plane respectively, and the height differences are different.

In some embodiments, the power charging copper bar output terminal, the power positive copper bar output terminal and the power negative copper bar output terminal have height differences relative to the horizontal plane, and the height differences are different.

In some embodiments, the power charging copper bar input terminal and the power charging copper bar output terminal have different height differences relative to the horizontal plane, the power positive copper bar input terminal and the power positive copper bar output terminal have different height differences relative to the horizontal plane, and the power negative copper bar input terminal and the power negative copper bar output terminal have different height differences relative to the horizontal plane.

In some embodiments, the power positive copper bar is disposed closer to an outer edge of the base relative to the power negative copper bar and the power charging copper bar.

In some embodiments, the power charging copper bar is disposed closer to an inner middle region of the base relative to the power positive copper bar and the power negative copper bar.

In some embodiments, the at least three stages of filter components include a first-stage filter component, a second-stage filter component, and a third-stage filter component that are respectively sleeved on the power charging copper bar, the power positive copper bar, and the power negative copper bar, and are respectively connected to the power charging copper bar, the power positive copper bar, and the power negative copper bar.

In some embodiments, the first-stage filter component is disposed closer to the power charging copper bar input terminal, the power positive copper bar input terminal, and the power negative copper bar input terminal relative to the second-stage filter component and the third-stage filter component.

In some embodiments, the first-stage filter component is arranged to extend along the first direction, and the second-stage filter component and the third-stage filter component are arranged to be distributed at intervals along the second direction.

In some embodiments, the first-stage filter component is integrally formed as an annular structure, and the power charging copper bar input terminal, the power positive copper bar input terminal, and the power negative copper bar input terminal are all disposed through the first-stage filter component and extend from the first-stage filter component to outside of the base.

In some embodiments, the second-stage filter component is a split structure and includes an upper part of the second-stage filter component and a lower part of the second-stage filter component, where the upper part of the second-stage filter component and the lower part of the second-stage filter component are vertically engaged by inserting, to be assembled above and below the power charging copper bar, the power positive copper bar and the power negative copper bar.

In some embodiments, the third-stage filter component is a split structure and includes an upper part of the third-stage filter component and a lower part of the third-stage filter component, where the upper part of the third-stage filter component and the lower part of the third-stage filter component are vertically engaged by inserting, to be assembled above and below the power charging copper bar, the power positive copper bar and the power negative copper bar.

In some embodiments, the first-stage filter component includes an amorphous magnetic ring.

In some embodiments, the second-stage filter component includes a ferrite magnetic ring.

In some embodiments, the third-stage filter component includes a ferrite magnetic ring.

In some embodiments, the filter further includes a printed circuit board, covering a top of the base, where differential-mode components, common-mode components, and direct-current support capacitor components are disposed on a surface of the printed circuit board facing the base; the filter further includes electrical connectors, respectively disposed on sides of the power charging copper bar, the power positive copper bar, and the power negative copper bar facing the printed circuit board, extending upward from tops of the power charging copper bar, the power positive copper bar, and the power negative copper bar, and electrically connected to the differential-mode components, the common-mode components, and the direct-current support capacitor components of the printed circuit board through vertical insertion.

In some embodiments, the filter further includes a grounding copper bar, where one end of each of the differential-mode components, the common-mode components, and the direct-current support capacitor components is connected to the grounding copper bar, and the grounding copper bar is connected to a ground terminal.

In some embodiments, each of the differential-mode components includes at least one differential-mode capacitor, and the differential-mode capacitor is connected between two of the power charging copper bar, the power positive copper bar, and the power negative copper bar.

In some embodiments, each of the common-mode components includes at least two common-mode capacitors, and each of the common mode capacitors is connected between a ground terminal and one of the power positive copper bar, the power negative copper bar, and the power charging copper bar.

In some embodiments, the filter further includes a current sensor disposed on the power positive copper bar.

In some embodiments, the direct-current power supply includes a direct-current boost power supply.

In some embodiments, the power positive copper bar is a positive copper busbar.

In some embodiments, the power negative copper bar is a negative copper busbar.

An embodiment of the present application further provides an electric drive controller, including the filter of the direct-current power supply according to any one of the above embodiments.

An embodiment of the present application further provides a vehicle, including the electric drive controller according to the above embodiments.

According to the filter of the direct-current power supply, the electric drive controller and the vehicle of the embodiments of the present application, the power charging copper bar, the power positive copper bar, the power negative copper bar, and the at least three stages of filter components are all mounted on the base, and the at least three stages of filter components are electrically connected to the power charging copper bar, the power positive copper bar, and the power negative copper bar, to supply power to the motor drive and at the same time implement the filtering function on the basis of the boost function, so that a very high resistance to insertion loss can be achieved, a relatively harsh filtering requirement is met, where integration is high, a structure is simple, a layout is compact, a volume is small, and maintenance costs are low.

Other aspects will become apparent upon reading and understanding the drawings and detailed description.

### BRIEF DESCRIPTION OF DRAWINGS

FIG. 1 is a circuit diagram of a filter circuit of a direct-current power supply according to an embodiment of the present application.
FIG. 2 is a structural diagram of a filter of a direct-current power supply according to an embodiment of the present application.
FIG. 3 is an exploded view of the filter of FIG. 2.
FIG. 4 is a structural top view of a filter for a direct-current power supply shown in FIG. 2.
FIG. 5 is a structural diagram of a part of a filter for a direct-current power supply shown in FIG. 2.
FIG. 6 is a structural diagram of a part of a filter for a direct-current power supply shown in FIG. 2.
FIG. 7 is a structural diagram of a part of a filter for a direct-current power supply shown in FIG. 2.
FIG. 8 is a structural diagram of a part of a filter for a direct-current power supply shown in FIG. 2.

Description of reference numerals: 1-filter circuit, 2-filter, 10-positive direct-current bus, 101-positive direct-current bus input terminal, 102-positive direct-current bus output terminal, 11-negative direct-current bus, 111-negative direct-current bus input terminal, 112-negative direct-current bus output terminal, 12-charging line, 121-charging line input terminal, 122-charging line output terminal, 13-at least three stages of filter circuits, 131-first-stage filter magnetic ring, 132-second-stage filter magnetic ring, 133-third-stage filter magnetic ring, 14-direct-current support capacitor, CL1-CL3: first to third direct-current support capacitors, 15-differential-mode circuit, CX1-CX3: first to third differential-mode capacitors, 16-common-mode circuit, CY 1-CY 12: first to twelfth common-mode capacitors, 21-base, 22-power charging copper bar, 221-power charging copper bar input terminal, 222-power charging copper bar output terminal, 23-power positive copper bar, 231-power positive copper bar input terminal, 232-power positive copper bar output terminal, 24-power negative copper bar, 241-power negative copper bar input terminal, 242-power negative copper bar output terminal, 25-at least three stages of filter components, 251-first-stage filter component, 252-second-stage filter component, 252a-upper part of the second-stage filter component, 252b-lower part of the second-stage filter component, 253-third-stage filter component, 253a-upper part of the third-stage filter component, 253b-lower part of the third-stage filter component, 26-printed circuit board, 27-electrical connector, 28-current sensor, X1-first direction, X2-second direction.

### DETAILED DESCRIPTION

Example embodiments will be described in detail herein, examples of which are illustrated in the accompanying drawings. When following description refers to the drawings, unless otherwise indicated, same numerals in different drawings indicate same or similar elements. The implementations set forth in the following description of example embodiments do not represent all implementations consistent with the present application. Instead, they are merely examples of apparatuses consistent with aspects related to the present application as recited in the appended claims.

The terminology used herein is for the purpose of describing particular embodiments only and is not intended to be limiting of the application. Unless otherwise defined, the technical terms or scientific terms used in the present application should have the ordinary meanings understood by those of ordinary skill in the art to which the present application belongs. "First", "second", and similar words used in the specification and claims of the present application do not indicate any order, quantity, or importance, but are merely used to distinguish between different components. Similarly, similar words such as "a" or "an" do not indicate quantity limitation, but indicate that there is at least one. Only "one" will be described separately. "Multiple" or "several" means two or more. Unless otherwise indicated, terms such as "front", "rear", "lower", and/or "upper" are merely for ease of description, and are not limited to one position or one spatial orientation. Similar words such as "include" or "comprise" mean that the elements or objects before "include" or "comprise" cover the elements or objects listed after "include" or "comprise" and their equivalents, and do not exclude other elements or objects. Similar words such as "connect" or "couple" are not limited to physical or mechanical connections, and may include electrical connections, whether direct or indirect. The singular forms "a", "said" and "the" used in the specification of the present disclosure and the appended claims are also intended to include plural forms, unless the context clearly indicates other meanings. It will also be understood that the term "and/or" as used herein refers to and encompasses any and all possible combinations of one or more of the associated listed items.

The 800 V high voltage and high power density electric drive controller represented by the third generation wide bandgap silicon carbide (SiC) power semiconductor has the advantages of high switching frequency, low loss and good temperature resistance to obtain large-scale applications, but also brings more serious electromagnetic interference problems. When the SiC power semiconductor device in the electric drive controller operates at a high speed, a high change rate of the du/dt voltage and a high change rate of the di/dt current will be generated, resulting in electromagnetic interference. Electromagnetic interference mainly includes radiation interference and conduction interference. The radiation interference refers to an electromagnetic wave generated by a product, which affects the normal operation of the electronic device through space interference, and the conduction interference refers to that an interference source affects the normal operation of other electronic devices in the form of voltage and current through a coupling path conducted by a high and low voltage wiring harness. In addition, interference may be classified into differential-mode interference and common-mode interference, where common-mode interference is a main factor that causes an electric drive controller to fail to meet a specified requirement. However, for a filter of a common direct-current power supply, stray inductance is relatively serious, and the filter insertion loss is high; the volume structure is inflexible and the output is easily affected by high-frequency coupling, and there are problems of unqualification and high maintenance cost in a high frequency band, which is not conducive to the popularization and application of platforms.

Embodiments of the present application discloses a filter of a direct-current power supply, an electric drive controller, and a vehicle. The filter of the direct-current power supply includes a base, a power charging copper bar, a power positive copper bar, a power negative copper bar and at least three stages of filter components. The power charging copper bar, the power positive copper bar, the power negative copper bar and the at least three stages of filter components are all assembled to the base, and the at least three stages of filtering components are electrically connected to the power charging copper bar, the power positive copper bar and the power negative copper bar, respectively.

According to the filter of the direct-current power supply, the electric drive controller and the vehicle of the embodiments of the present application, the power charging copper bar, the power positive copper bar, the power negative copper bar, and the at least three stages of filter components are all mounted on the base, and the at least three stages of filter components are electrically connected to the power charging copper bar, the power positive copper bar, and the power negative copper bar, to supply power to the motor drive and at the same time implement the filtering function on the basis of the boost function, so that a very high resistance to insertion loss can be achieved, a relatively harsh filtering requirement is met, where integration is high, a structure is simple, a layout is compact, a volume is small, and maintenance costs are low.

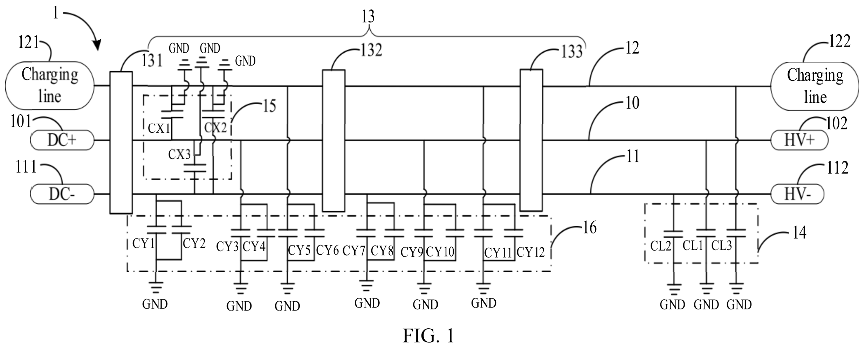

FIG. 1 is a circuit diagram of a filter circuit of a direct-current power supply according to an embodiment of the present application. As shown in FIG. 1, the filter circuit 1 for the direct-current power supply includes a positive direct-current bus 10, a negative direct-current bus 11, a charging line 12, and at least three stages of filter circuits 13. The positive direct-current bus 10 includes a positive direct-current bus input terminal 101 and a positive direct-current bus output terminal 102. The negative direct-current bus 11 includes a negative direct-current bus input terminal 111 and a negative direct-current bus output terminal 112. The charging line 12 includes a charging line input terminal 121 and a charging line output terminal 122. The at least three stages of filter circuits 13 are respectively connected between the positive direct-current bus input terminal 101 and the positive direct-current bus output terminal 102, between the negative direct-current bus input terminal 111 and the negative direct-current bus output terminal 112, and between the charging line input terminal 121 and the charging line output terminal 122.

In an embodiment, the charging line and the direct-current bus (the positive direct-current bus and the negative direct-current bus) are integrated as a whole, and at least three stages of filter circuits 13 are disposed between the integrated input terminals and output terminals, so that power can be supplied to the motor drive and at the same time a filtering function can be implemented on the basis of a boost function, thereby achieving a high resistance to insertion loss, and meeting a relatively strict filtering requirement.

In an embodiment shown in FIG. 1, the at least three stages of filter circuits 13 include a first-stage filter magnetic ring 131, a second-stage filter magnetic ring 132, and a third-stage filter magnetic ring 133. The first-stage filter magnetic ring 131, the second-stage filter magnetic ring 132, and the third-stage filter magnetic ring 133 are sequentially connected at intervals between the positive direct-current bus input terminal 101 and the positive direct-current bus output terminal 102, between the negative direct-current bus input terminal 111 and the negative direct-current bus output terminal 112, and between the charging line input terminal 121 and the charging line output terminal 122. The first-stage filter magnetic ring 131 is configured to eliminate low-frequency electromagnetic interference. The second-stage filter magnetic ring 132 and the third-stage filter magnetic ring 133 are configured to eliminate high-frequency electromagnetic interference. The first-stage filter magnetic ring 131, the second-stage filter magnetic ring 132 and the third-stage filter magnetic ring 133 are connected at intervals, which can supply power to the motor drive and at the same time realize the filtering function on the basis of the boost function, and can achieve a high resistance to insertion loss and meet the relatively strict filtering requirements.

In an embodiment shown in FIG. 1, the first-stage filter magnetic ring 131 is disposed closer to the positive direct-current bus input terminal 101, the negative direct-current bus input terminal 111, and the charging line input terminal 121 relative to the second-stage filter magnetic ring 132 and the third-stage filter magnetic ring 133. As the input terminals of the positive direct-current bus 10, the negative direct-current bus 11 and the charging line 12 have much low-frequency electromagnetic interference, in this embodiment, the first-stage filter magnetic ring 131 is disposed closer to the positive direct-current bus input terminal 101, the negative direct-current bus input terminal 111 and the charging line input terminal 121, which can eliminate low-frequency electromagnetic interference and make the signal stable and reliable.

In an embodiment shown in FIG. 1, the at least three stages of filter circuits 13 further include multiple direct-current support capacitors 14 respectively connected between the positive direct-current bus 10 and a ground terminal GND, between the negative direct-current bus 11 and a ground terminal GND, and between the charging line 12 and a ground terminal GND. In an embodiment shown in FIG. 1, connection points between the multiple direct-current support capacitors 14 and the positive direct-current bus 10, the negative direct-current bus 11, and the charging line 12 are respectively located between the third-stage filter magnetic ring 133 and the positive direct-current bus output terminal 102, between the third-stage filter magnetic ring 133 and the negative direct-current bus output terminal 112, and between the third-stage filter magnetic ring 133 and the charging line output terminal 122.

The multiple direct-current support capacitors 14 in this embodiment may perform smooth filtering on output voltages of the positive direct-current bus 10, the negative direct-current bus 11, and the charging line 12, so that voltage fluctuations on the charging line 12 and the direct-current bus (the positive direct-current bus 10 and the negative direct-current bus 11) are kept within an allowed range. The direct-current support capacitors 14 have the advantages of high voltage resistance, high current resistance, low impedance, low inductance, small capacity loss, small leakage current, safety and reliability, etc.

For example, in an embodiment shown in FIG. 1, the multiple direct-current support capacitors 14 may specifically include a first direct-current support capacitor CL 1, a second direct-current support capacitor CL2, and a third direct-current support capacitor CL3. The first direct-current support capacitor CL1 is connected between the positive direct-current bus 10 and the ground terminal GND, the second direct-current support capacitor CL2 is connected between the negative direct-current bus 11 and the ground terminal GND, and the third direct-current support capacitor CL3 is connected between the charging line 12 and the ground terminal GND. The first direct-current support capacitor CL1 may perform smooth filtering on the output voltage of the positive direct-current bus 10, so that a voltage fluctuation on the positive direct-current bus 10 is kept within an allowable range, thereby suppressing ripples and preventing backflow. The second direct-current support capacitor CL2 may perform smooth filtering on the output voltage of the negative direct-current bus 11, so that a voltage fluctuation on the negative direct-current bus 11 is kept within an allowable range, thereby suppressing ripples and preventing backflow. The third direct-current support capacitor CL3 may perform smooth filtering on the output voltage of the charging line 12, so that the voltage fluctuation on the charging line 12 is kept within an allowable range, thereby suppressing ripples and preventing backflow.

In an embodiment shown in FIG. 1, one end of each of the multiple direct-current support capacitors 14 is connected to the ground terminal GND, where a connection manner thereof is flexible. In some other embodiments, one end of each of the multiple direct-current support capacitors 14 may also be connected to the same ground terminal GND, and the ground terminal in this connection manner is relatively more stable and reliable.

In an embodiment shown in FIG. 1, the at least three stages of filter circuits 13 may further include at least one differential-mode circuit 15 connected to every two of the positive direct-current bus 10, the negative direct-current bus 11, and the charging line 12. In an embodiment shown in FIG. 1, each differential-mode circuit 15 includes at least one differential-mode capacitor CX. In some embodiments, each differential-mode capacitor is connected between two of the positive direct-current bus 10, the negative direct-current bus 11, and the charging line 12. This arrangement can improve the performance of eliminating differential-mode interference signals.

For example, in an embodiment shown in FIG. 1, the differential-mode capacitor CX may specifically include a first differential-mode capacitor CX1, a second differential-mode capacitor CX2, and a third differential-mode capacitor CX3. The first differential-mode capacitor CX1 is connected between the positive direct-current bus 10 and the charging line 12, and is configured to eliminate differential-mode interference between the positive direct-current bus 10 and the charging line 12. The second differential-mode capacitor CX2 is connected between the negative direct-current bus 11 and the charging line 12, and is configured to eliminate differential-mode interference between the negative direct-current bus 11 and the charging line 12. The third differential-mode capacitor CX3 is connected between the positive direct-current bus 10 and the negative direct-current bus 11, and is configured to eliminate differential-mode interference between the positive direct-current bus 10 and the negative direct-current bus 11.

In an embodiment shown in FIG. 1, connection points between the differential-mode circuits 15 and the positive direct-current bus 10, the negative direct-current bus 11, and the charging line 12 are respectively located between the first-stage filter magnetic ring 131 and the second-stage filter magnetic ring 132. In this way, mutual interference between the first-stage filter magnetic ring 131 and the second-stage filter magnetic ring 132 can be reduced.

In an embodiment shown in FIG. 1, the at least three stages of filter circuits 13 may further include one or more common-mode circuits 16 respectively connected between the positive direct-current bus 10 and the ground terminal GND, between the negative direct-current bus 11 and the ground terminal GND, and between the charging line 12 and the ground terminal GND. In an embodiment shown in FIG. 1, connection points between the common-mode circuits 16 and the positive direct-current bus 10, the negative direct-current bus 11, and the charging line 12 are respectively located between the first-stage filter magnetic ring 131 and the second-stage filter magnetic ring 132, and between the second-stage filter magnetic ring 132 and the third-stage filter magnetic ring 133. In an embodiment shown in FIG. 1, each common-mode circuit 16 includes at least two common-mode capacitors CY. In some embodiments, each common-mode capacitor is connected between the ground terminal and one of the positive direct-current bus 10, the negative direct-current bus 11, and the charging line 12. This arrangement can improve the performance of eliminating common-mode interference.

For example, in an embodiment shown in FIG. 1, common-mode capacitors CYs with non-grounded connection points between the first-stage filter magnetic ring 131 and the second-stage filter magnetic ring 132, may specifically include: a first common-mode capacitor CY1 and a second common-mode capacitor CY2, connected between the negative direct-current bus 11 and the ground terminal GND, and configured to eliminate common-mode interference between the negative direct-current bus 11 and the ground terminal GND; a third common-mode capacitor CY3 and a fourth common-mode capacitor CY4, connected between the positive direct-current bus 10 and the ground terminal GND, and configured to eliminate common-mode interference between the positive direct-current bus 10 and the ground terminal GND; and a fifth common-mode capacitor CY5 and a sixth common-mode capacitor CY6, connected between the charging line 12 and the ground terminal GND, and configured to eliminate common-mode interference between the charging line 12 and the ground terminal GND.

For another example, in the embodiment shown in FIG. 1, common-mode capacitors CYs with non-grounded connection points between the second-stage filter magnetic ring 132 and the third-stage filter magnetic ring 133, may specifically include: a seventh common-mode capacitor CY7 and an eighth common-mode capacitor CY8, connected between the negative direct-current bus 11 and the ground terminal GND, and configured to eliminate common-mode interference between the negative direct-current bus 11 and the ground terminal GND; a ninth common-mode capacitor CY9 and a tenth common-mode capacitor CY 10, connected between the positive direct-current bus 10 and the ground terminal GND, and configured to eliminate common-mode interference between the positive direct-current bus 10 and the ground terminal GND; and an eleventh common-mode capacitor CY11 and a twelfth common-mode capacitor CY12, connected between the charging line 12 and the ground terminal GND, and configured to eliminate common-mode interference between the charging line 12 and the ground terminal GND.

In addition, in the embodiment shown in FIG. 1, one end of each of the multiple common-mode circuits 16 is connected to the ground terminal GND, where a connection manner thereof is flexible. In some other embodiments, one end of the multiple common-mode circuits 16 may be connected to the same ground terminal GND, and the ground terminal in this connection manner is relatively more stable and reliable.

In an embodiment shown in FIG. 1, the first-stage filter magnetic ring 131 may include an amorphous magnetic ring. The amorphous magnetic ring is a magnetic element processed with an amorphous material, and can well inhibit low-frequency interference signals. Materials used as the amorphous material can be classified into iron-based amorphous, cobalt-based amorphous, etc. In this embodiment, the amorphous magnetic ring can be replaced with magnetic rings of different shapes and materials according to actual filtering requirements of different products to achieve a desired inductance.

In an embodiment shown in FIG. 1, the second-stage filter magnetic ring 132 may include a ferrite magnetic ring. In an embodiment shown in FIG. 1, the third-stage filter magnetic ring 133 may also include a ferrite magnetic ring, for example, the ferrite magnetic ring is made of a ferrite material (Mn-Zn). The ferrite magnetic ring has a good inhibitory effect on high-frequency interference signals.

An embodiment of the present application further provides a filter 2 for a direct-current power supply, and the filter 2 for the direct-current power supply is provided with the filter circuit 1 for the direct-current power supply shown in the embodiment of FIG. 1. The direct-current power supply may include a direct-current boost power supply (boost power supply). The filter 2 integrates the charging line 12 and the direct-current bus (the positive direct-current bus 10 and the negative direct-current bus 11) as a whole by disposing the filter circuit 1 for the direct-current power supply shown in the embodiment of FIG. 1, and at least three stages of filter circuits 13 are disposed between the integrated input terminals and output terminals, so that power can be supplied to the motor drive and at the same time a filtering function can be implemented on the basis of a boost function, and a very high resistance to insertion loss can be achieved, thereby meeting a relatively strict filtering requirement.

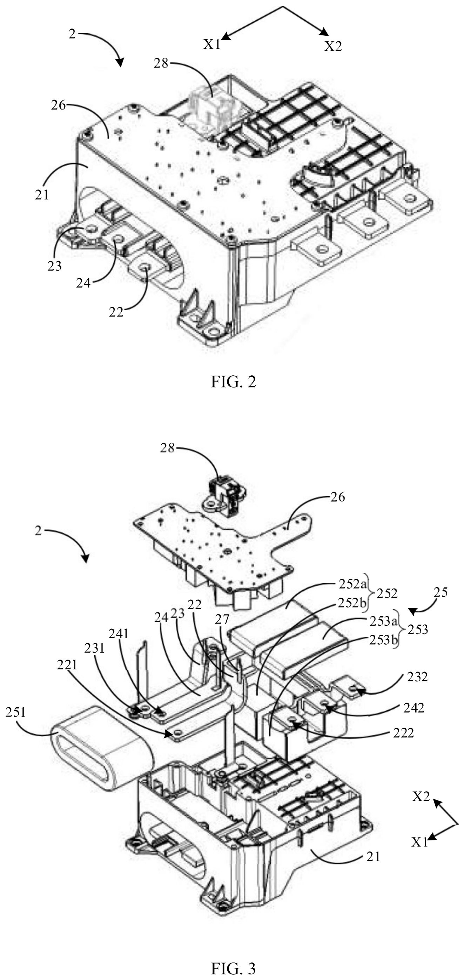

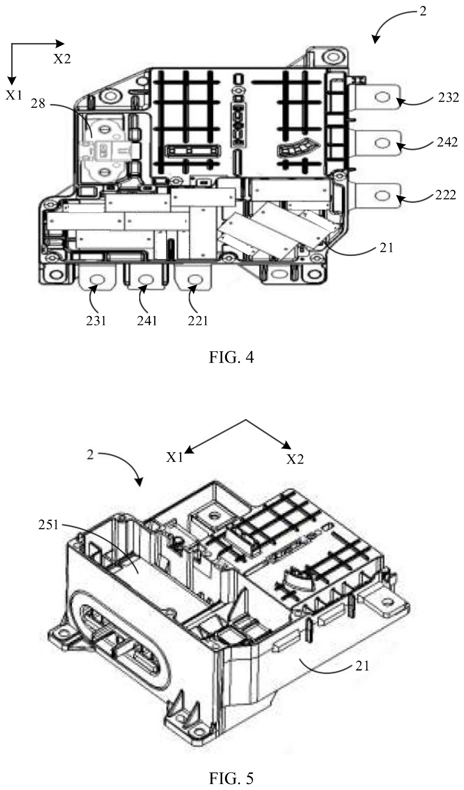

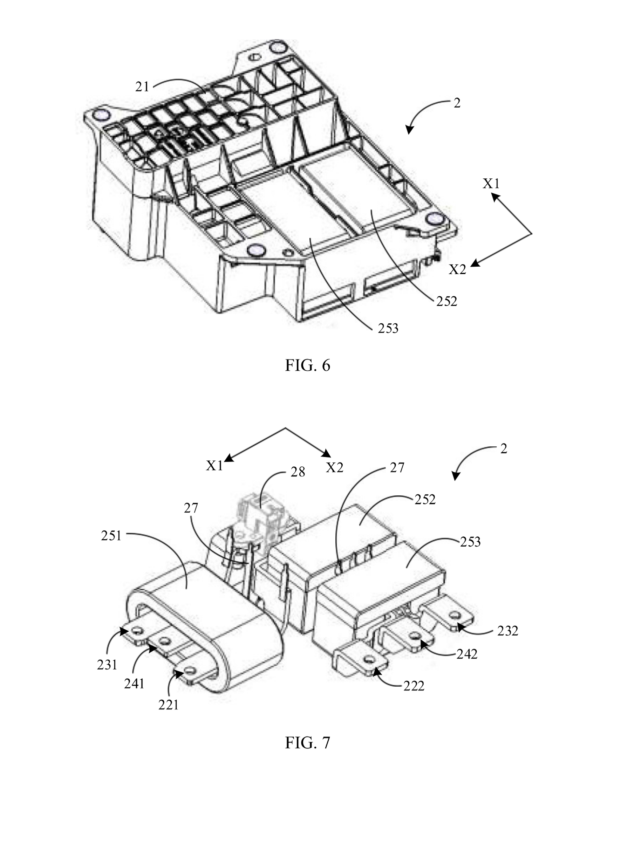

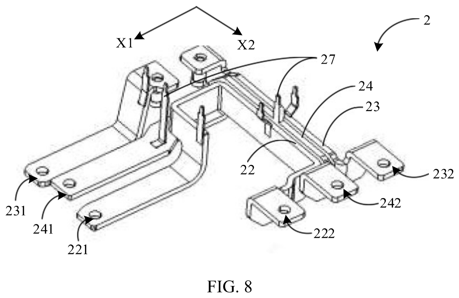

FIG. 2 is a schematic structural diagram of an embodiment of a filter 2 for a direct-current power supply according to the present application. FIG. 3 is an exploded view of the filter 2 of FIG. 2. FIG. 4 is a structural top view of a filter 2 for a direct-current power supply shown in FIG. 2. FIG. 5 is a structural diagram of a part of a filter 2 for a direct-current power supply shown in FIG. 2. FIG. 6 is a structural diagram of a part of a filter 2 for a direct-current power supply shown in FIG. 2. FIG. 7 is a structural diagram of a part of a filter 2 for a direct-current power supply shown in FIG. 2. FIG. 8 is a structural diagram of a part of a filter 2 for a direct-current power supply shown in FIG. 2. As shown in FIG. 2 to FIG. 8, the filter 2 for the direct-current power supply includes a base 21, a power charging copper bar 22, a power positive copper bar 23, a power negative copper bar 24, and at least three stages of filter components 25. The power charging copper bar 22, the power positive copper bar 23, the power negative copper bar 24, and the at least three stage filter components 25 are all mounted on the base 21. The base 21 is provided with an accommodating space for accommodating the power charging copper bar 22, the power positive copper bar 23, the power negative copper bar 24 and at least three stages of filter components 25. The at least three stages of filter components 25 are electrically connected to the power charging copper bar 22, the power positive copper bar 23, and the power negative copper bar 24, respectively. In this embodiment, the power positive copper bar 23 may be a positive copper busbar. The power negative copper bar 24 may be a negative copper busbar.

In this embodiment, the power charging copper bar 22, the power positive copper bar 23, the power negative copper bar 24, and the at least three stages of filter components 25 are all mounted on the base 21, and the at least three stages of filter components 25 are electrically connected to the power charging copper bar 22, the power positive copper bar 23, and the power negative copper bar 24, to supply power to the motor drive and at the same time implement the filtering function on the basis of the boost function, so that a very high resistance to insertion loss can be achieved, a relatively harsh filtering requirement is met, where integration is high, a structure is simple, a layout is compact, a volume is small, and maintenance costs are low.

In embodiments shown in FIG. 2 to FIG. 3, and FIG. 7 to FIG. 8, the base 21 extends along a first direction X1 and a second direction X2 that are located in a same plane and intersect with each other. In this embodiment, the first direction X1 and the second direction X2 may be perpendicularly intersected. The power charging copper bar 22 includes a power charging copper bar input terminal 221 and a power charging copper bar output terminal 222 that are connected to each other. In this embodiment, the power charging copper bar input terminal 221 and the power charging copper bar output terminal 222 are both bent and connected to the filter components 25. The power positive copper bar 23 includes a power positive copper bar input terminal 231 and a power positive copper bar output terminal 232 that are connected to each other. The power positive copper bar input terminal 231 and the power positive copper bar output terminal 232 are both bent and connected to the filter components 25. The power negative copper bar 24 includes a power negative copper bar input terminal 241 and a power negative copper bar output terminal 242 that are connected to each other. The power negative copper bar input terminal 241 and the power negative copper bar output terminal 242 are both bent and connected to the filter components 25. In addition, as shown in FIG. 2 to FIG. 8, the power charging copper bar input terminal 221, the power positive copper bar input terminal 231 and the power negative copper bar input terminal 241 extend side by side along the first direction X1, and the power charging copper bar output terminal 222, the power positive copper bar output terminal 232 and the power negative copper bar output terminal 242 extend side by side along the second direction X2. In this way, by combining the placement form of parallel disposed copper bars and the placement form of vertically laminated copper bars, the bending angle of the copper bar can be adjusted to be compatible with various spatial structures, which has the advantages of simple structure, high integration, compact layout and low maintenance cost.

In the embodiments shown in FIG. 2 to FIG. 3, and FIG. 7 to FIG. 8, the power charging copper bar input terminal 221, the power positive copper bar input terminal 231, and the power negative copper bar input terminal 241 respectively have a height difference relative to a plane in which the first direction X1 and the second direction X2 are located, and the height differences are different. In an embodiment, it is assumed that the plane where the first direction X1 and the second direction X2 are located is a horizontal plane. The power charging copper bar input terminal 221, the power positive copper bar input terminal 231, and the power negative copper bar input terminal 241 respectively have a height difference relative to the horizontal plane, and the height differences may be different from each other. With this arrangement, the input signals of the power charging copper bar input terminal 221, the power positive copper bar input terminal 231 and the power negative copper bar input terminal 241 can be prevented from interfering with each other, so that the input signals are stable and reliable.

In the embodiments shown in FIG. 2 to FIG. 3 and FIG. 7 to FIG. 8, the power charging copper bar output terminal 222, the power positive copper bar output terminal 232, and the power negative copper bar output terminal 242 have a height difference relative to a plane in which the first direction X1 and the second direction X2 are located, and the height differences are different. In an embodiment, it is assumed that the plane where the first direction X1 and the second direction X2 are located is a horizontal plane. The power charging copper bar output terminal 222, the power positive copper bar output terminal 232, and the power negative copper bar output terminal 242 respectively have a height difference relative to the horizontal plane, and the height differences may be different from each other. With this arrangement, the output signals of the power charging copper bar output terminal 222, the power positive copper bar output terminal 232 and the power negative copper bar output terminal 242 can be prevented from interfering with each other, so that the output signals are stable and reliable.

In the embodiments shown in FIG. 2 to FIG. 3 and FIG. 7 to FIG. 8, the power charging copper bar input terminal 221, the power positive copper bar input terminal 231, and the power negative copper bar input terminal 241 respectively have a height difference relative to the power charging copper bar output terminal 222, the power positive copper bar output terminal 232, and the power negative copper bar output terminal 242 in the plane where the first direction X1 and the second direction X2 are located. In an embodiment, it is assumed that the plane where the first direction X1 and the second direction X2 are located is a horizontal plane. The power charging copper bar input terminal 221 may have a height difference on the horizontal plane relative to the power charging copper bar output terminal 222. The power positive copper bar input terminal 231 may have a height difference on the horizontal plane relative to the power positive copper bar output terminal 232. The power negative copper bar input terminal 241 may have a height difference on the horizontal plane relative to the power negative copper bar output terminal 242 . This arrangement can further avoid signal interference and make signal transmission more stable and reliable.

In the embodiments shown in FIG. 2 to FIG. 3 and FIG. 7 to FIG. 8, the power positive copper bar 23 may be disposed closer to an outer edge of the base 21 relative to the power negative copper bar 24 and the power charging copper bar 22; and the power charging copper bar 22 may be disposed closer to an inner middle region of the base 21 relative to the power positive copper bar 23 and the power negative copper bar 24. For example, the power positive copper bar 23, the power negative copper bar 24, and the power charging copper bar 22 may be sequentially arranged from the edge of the base 21 to the middle area. In addition, the power positive copper bar input terminal 231 and the power positive copper bar output terminal 232 may respectively extend in two directions. For example, the power positive copper bar input terminal 231 extends along the first direction X1, and the power positive copper bar output terminal 232 extends along the second direction X2. Similarly, the power negative copper bar input terminal 241 and the power negative copper bar output terminal 242 may also respectively extend in two directions (the power negative copper bar input terminal 241 extends along the first direction X1 and the power negative copper bar output terminal 242 extends along the second direction X2), and the power charging copper bar input terminal 221 and the power charging copper bar output terminal 222 may also respectively extend in two directions (the power charging copper bar input terminal 221 extends along the first direction X1 and the power charging copper bar output terminal 222 extends along the second direction X2).

In this embodiment, by arranging the copper bars along two vertical directions, the space of the bending part can be fully utilized, and through the structural design of parallel laminated copper bars, where parallel refers to parallel projection on the horizontal plane, and laminated refers to different height differences relative to the horizontal plane, which can maximize the laminated length range of the power positive copper bar 23, the power negative copper bar 24 and the power charging copper bar 22, so that magnetic fields of the power positive copper bar 23, the power negative copper bar 24 and the power charging copper bar 22 cancel each other, and can effectively reduce stray inductance. In addition, in this layout manner, a structure is simple, a layout is compact, integration is high, and a volume is small. It should be noted that an isolation component (not shown in the figure) is disposed between adjacent copper bars for isolation, to prevent electrical connection between the adjacent copper bars.

In the embodiments shown in FIG. 3 and FIG. 5 to FIG. 7, the at least three stages of filter components 25 include a first-stage filter component 251, a second-stage filter component 252, and a third-stage filter component 253, which are respectively sleeved on the power charging copper bar 22, the power positive copper bar 23, and the power negative copper bar 24, and are respectively connected to the power charging copper bar 22, the power positive copper bar 23, and the power negative copper bar 24.

With reference to FIG. 1, the first-stage filter component 251 shown in FIG. 2 to FIG. 8 may be the first-stage filter magnetic ring 131, and the first-stage filter magnetic ring 131 may be an amorphous magnetic ring. The second-stage filter component 252 may be the second-stage filter magnetic ring 132, and the third-stage filter component 253 may be the third-stage filter magnetic ring 133. The second-stage filter magnetic ring 132 and the third-stage filter magnetic ring 133 may be ferrite magnetic rings. The first-stage filter component 251 is configured to eliminate low-frequency electromagnetic interference. The second-stage filter component 252 and the third-stage filter component 253 are configured to eliminate high-frequency electromagnetic interference. In this way, power can be supplied to the motor drive and at the same time the filtering function can be realized on the basis of the boost function, which can achieve a high resistance to insertion loss, thereby meeting the relatively strict filtering requirements.

In the embodiments shown in FIG. 5 and FIG. 7, the first-stage filter component 251 is disposed closer to the power charging copper bar input terminal 221, the power positive copper bar input terminal 231, and the power negative copper bar input terminal 241 relative to the second-stage filter component 252 and the third-stage filter component 253. As the input terminals of the power charging copper bar 22, the power positive copper bar 23 and the power negative copper bar 24 have much low-frequency electromagnetic interference, the first-stage filter component 251 is arranged closer to the power charging copper bar input terminal 221, the power positive copper bar input terminal 231 and the power negative copper bar input terminal 241, which can eliminate the low-frequency electromagnetic interference and make the signal stable and reliable.

In the embodiments shown in FIG. 3 and FIG. 5 to FIG. 7, the first-stage filter component 251 is arranged to extend along the first direction X1, and the second-stage filter component 252 and the third-stage filter component 253 are arranged at intervals along the second direction X2. In this way, the spatial structure of the load can be compatible, the layout is compact, and mutual interference between the first-stage filter component 251, the second-stage filter component 252, and the third-stage filter component 253 is prevented.

In the embodiments shown in FIG. 3 and FIG. 5 to FIG. 7, the first-stage filter component 251 is integrally formed and has a ring structure, and the power charging copper bar input terminal 221, the power positive copper bar input terminal 231, and the power negative copper bar input terminal 241 may all pass through the first-stage filter component 251 and extend from the first-stage filter component 251 to the outside of the base 21.

In the embodiments shown in FIG. 2 to FIG. 8, the second-stage filter component 252 may be a split structure, including an upper part 252a of the second-stage filter component and a lower part 252b of the second-stage filter component. The upper part 252a of the second-stage filter component and the lower part 252b of the second-stage filter component can be vertically assembled by inserting, so as to be assembled above and below the power charging copper bar 22, the power positive copper bar 23, and the power negative copper bar 24.

In the embodiments shown in FIG. 2 to FIG. 8, the third-stage filter component 253 may also be a split structure, including an upper part 253a of the third-stage filter component and a lower part 253b of the third-stage filter component. The upper part 253a of the third-stage filter component and the lower part 253b of the third-stage filter component can be vertically assembled by inserting, so as to be assembled above and below the power charging copper bar 22, the power positive copper bar 23, and the power negative copper bar 24.

In order to be compatible with a complex spatial structure, the first-stage filter component 251 is assembled parallel to the input terminal of the copper bar, and a size of the magnetic ring is compatible with different spatial sizes for actual adjustment. The second-stage filter components 252 and the third-stage filter component 253 are assembled in segments, and the assembly direction is orthogonal to the assembly direction of the first-stage filter component 251. In this way, configuration of the magnetic ring is convenient and flexible, takes into account the structure size and process, and facilitates the promotion and application of the platform.

In the embodiments shown in FIG. 2 to FIG. 3, the filter 2 may further include a printed circuit board 26 covering the top of the base 21. The printed circuit board 26 is assembled on the top of the base 21, on one hand, the power charging copper bar 22, the power positive copper bar 23, the power negative copper bar 24, and the at least three stages of filter components 25 are assembled in the base 21, and are fixed stably; and on the other hand, the power positive copper bar 23, the power negative copper bar 24, and the at least three stages of filter components 25 are electrically connected to the printed circuit board 26, so that the electrical connection is stable and reliable, and signal transmission is stable. In this embodiment, the printed circuit board 26 is used to replace the traditional direct connection mode of the capacitor pins, which not only facilitates the capacitor layout, but also reduces the parasitic resistance and inductance through the wider wiring on the printed circuit board 26.

In this embodiment, on the basis of the parallel laminated vertical structure of the copper bar, screws are fastened to the printed circuit board 26 to obtain power, which is convenient for installation and disassembly. In this embodiment, protection measures, such as a magnetic ring, a Y capacitor (CX capacitor), and an X capacitor (CY capacitor), are selectively designed from the system level to prevent structural damage. In this embodiment, multiple differential-mode components (not shown), multiple common-mode components (not shown), and multiple direct-current support capacitor components (not shown) are disposed on a surface of the printed circuit board 26 facing the base 21. As shown in FIG. 1, the direct-current support capacitor component may be the direct-current support capacitors 14, which are respectively connected between the power charging copper bar 22 and the ground terminal, between the power positive copper bar 23 and the ground terminal, and between the power negative copper bar 24 and the ground terminal. The differential-mode component may be differential-mode capacitors of the differential-mode circuit 15. Each differential-mode component includes at least one differential-mode capacitor, and each differential-mode capacitor is connected between two of the power charging copper bar 22, the power positive copper bar 23, and the power negative copper bar 24. The common-mode component may be the common-mode capacitors of the common-mode circuit 16. Each common-mode component includes at least two common-mode capacitors, and each common-mode capacitor is connected between one of the power positive copper bar 23, the power negative copper bar 24, and the power charging copper bar 22 and the ground terminal. In addition, the printed circuit board 26 further includes other elements, which is not limited in the present application. In this embodiment, the multiple differential-mode components, the multiple common-mode components, and the multiple direct-current support capacitor components are disposed in the filter 2, and the built-in arrangement can reduce the size of the product in the height direction, so that the structure is compact and the volume is reduced.

With reference to the embodiments shown in FIG. 3 and FIG. 7 to FIG. 8, the filter 2 may further include multiple electrical connectors 27, which are respectively disposed on a side of the power charging copper bar 22, the power positive copper bar 23, and the power negative copper bar 24 facing the printed circuit board 26, extend upward from tops of the power charging copper bar 22, the power positive copper bar 23, and the power negative copper bar 24, and are electrically connected to the multiple differential-mode components, the multiple common-mode components, and the multiple direct-current support capacitor components of the printed circuit board 26 in a vertical manner. In this embodiment, the electrical connector 27 may be a plug-in copper bar, which is integrally formed with the power charging copper bar 22, the power positive copper bar 23, and the power negative copper bar 24, respectively. In this embodiment, by providing multiple plug-in copper bars, on the one hand, the structural layout is compact and the molding process is simple, and on the other hand, the plug-in connection with the components on the printed circuit board 26 is realized, the signal is stable, and the assembly is convenient. In this embodiment, the electrical connector 27 may be a copper bar pin, which is different from a conventional bolt fixing, and can not only ensure a current passing capability, but also achieve a filtering effect.

In this embodiment, the filter 2 may further include a grounded copper bar (not shown). One end of each of the multiple differential-mode components, the multiple common-mode components, and the multiple direct-current support capacitor components is connected to a grounded copper bar, and the grounded copper bar is connected to a ground terminal. In some embodiments, the differential-mode components are grounded through a Y capacitor. In this way, the grounded terminals of the multiple differential-mode components, the multiple common-mode components, and the multiple direct-current support capacitor components can be together connected to the grounded copper bar, which is, on the one hand, convenient for connection and maintenance, and on the other hand, has a large grounded area and stable grounded signals. In addition, in combination with the actual space, multiple paths are connected to the same grounded copper bar in parallel, and the length of the common-mode grounded line is reduced to the greatest extent by means of multi-point parallel connection to the ground, the grounded impedance is reduced, and high-frequency clutter is filtered out. In this embodiment, the filter grounding of the common-mode capacitor and the product fixing hole position are integrated, which can reduce the number of fixing hole positions and further reduce the volume.

With reference to the embodiments shown in FIG. 2 to FIG. 4 and FIG. 7, the filter 2 may further include a current sensor 28 disposed on the power positive copper bar 23. The current sensor 28 is configured to detect a current of the power positive copper bar 23, that is, detect a current of the direct-current bus loop, and can monitor the current of the direct-current bus loop in real time, which is safe and reliable. In this embodiment, the filter 2 may further include a voltage sensor, which is highly integrated.

An embodiment of the present application further provides an electric drive controller, including the filter 2 for the direct-current power supply according to the above embodiments of FIG. 2 to FIG. 8. In this embodiment, the electric drive controller is provided with the filter 2 for the direct-current power supply shown in the embodiments of FIG. 2 to FIG. 8. This embodiment mainly addresses the problem of poor/common-mode interference caused by the high voltage, high switching frequency, and wide bandgap power module operation of the electric drive controller, and under the premise of ensuring the performance, size, and cost, through the solution of distributively arranging at least three stages of filters 2 in the electric drive controller, the first-stage filter component 251, the second-stage filter component 252, and the third-stage filter component 253 are externally arranged to facilitate material formula adjustment, and the common-mode capacitor of the common-mode component, the differential-mode capacitor of the differential-mode component, and the direct-current support capacitor of the direct-current support capacitor component are internally arranged to facilitate structural integration and achieve a good electromagnetic compatibility design target requirement. On the premise of not changing the size, the electric drive controller is selected from the entire control system level, which realizes the flexible configuration of design topology and structure optimization, ensures the reliability, and is beneficial to the promotion and application of the platform, and can be applied to the system solutions of the front drive and rear drive, the double motor and the four motor. An embodiment of the present application further provides a vehicle, including the electric drive controller in the above embodiments, which is stable and reliable, can meet a good electromagnetic compatibility design objective requirement, has better stability, better safety, and better compatibility, and is conducive to promotion and application of a platform.

The above embodiments are some embodiments of the present application, but are not intended to limit the present application, and any modification, equivalent replacement, improvement, and the like made without departing from the spirit and principle of this application shall fall within the protection scope of the present application.

## Claims

1. A filter of a direct-current power supply, comprising:
a base;
a power charging copper bar, assembled to the base;
a power positive copper bar, assembled to the base;
a power negative copper bar, assembled to the base; and
at least three stages of filter components, wherein the at least three stages of filter components are assembled to the base and are electrically connected to the power charging copper bar, the power positive copper bar and the power negative copper bar respectively.

2. The filter of the direct-current power supply according to claim 1, wherein
the base extends along a first direction and a second direction that are located in a same horizontal plane and intersect with each other;
the power charging copper bar comprises a power charging copper bar input terminal and a power charging copper bar output terminal;
the power positive copper bar comprises a power positive copper bar input terminal and a power positive copper bar output terminal;
the power negative copper bar comprises a power negative copper bar input terminal and a power negative copper bar output terminal;
wherein the power charging copper bar input terminal, the power positive copper bar input terminal, and the power negative copper bar input terminal extend side by side along the first direction, and
wherein the power charging copper bar output terminal, the power positive copper bar output terminal, and the power negative copper bar output terminal extend side by side along the second direction.

3. The filter of the direct-current power supply according to claim 2, wherein
the power charging copper bar input terminal, the power positive copper bar input terminal and the power negative copper bar input terminal have height differences relative to the horizontal plane respectively, and the height differences are different; and/or
the power charging copper bar output terminal, the power positive copper bar output terminal and the power negative copper bar output terminal have height differences relative to the horizontal plane, and the height differences are different;
the power charging copper bar input terminal and the power charging copper bar output terminal have different height differences relative to the horizontal plane, the power positive copper bar input terminal and the power positive copper bar output terminal have different height differences relative to the horizontal plane, and the power negative copper bar input terminal and the power negative copper bar output terminal have different height differences relative to the horizontal plane.

4. The filter of the direct-current power supply according to claim 2, wherein
the power positive copper bar is disposed closer to an outer edge of the base relative to the power negative copper bar and the power charging copper bar; and/or
the power charging copper bar is disposed closer to an inner middle region of the base relative to the power positive copper bar and the power negative copper bar.

5. The filter of the direct-current power supply according to claim 2, wherein the at least three stages of filter components comprise a first-stage filter component, a second-stage filter component, and a third-stage filter component that are respectively sleeved on the power charging copper bar, the power positive copper bar, and the power negative copper bar, and are respectively connected to the power charging copper bar, the power positive copper bar, and the power negative copper bar.

6. The filter of the direct-current power supply according to claim 5, wherein the first-stage filter component is disposed closer to the power charging copper bar input terminal, the power positive copper bar input terminal, and the power negative copper bar input terminal relative to the second-stage filter component and the third-stage filter component.

7. The filter of the direct-current power supply according to claim 5, wherein
the first-stage filter component is arranged to extend along the first direction,
the second-stage filter component and the third-stage filter component are arranged to be distributed at intervals along the second direction.

8. The filter of the direct-current power supply according to claim 5, wherein
the first-stage filter component is integrally formed as an annular structure, and the power charging copper bar input terminal, the power positive copper bar input terminal, and the power negative copper bar input terminal are all disposed through the first-stage filter component and extend from the first-stage filter component to outside of the base; and/or
the second-stage filter component is a split structure and comprises an upper part of the second-stage filter component and a lower part of the second-stage filter component, wherein the upper part of the second-stage filter component and the lower part of the second-stage filter component are vertically engaged by inserting, to be assembled above and below the power charging copper bar, the power positive copper bar and the power negative copper bar; and/or
the third-stage filter component is a split structure and comprises an upper part of the third-stage filter component and a lower part of the third-stage filter component, wherein the upper part of the third-stage filter component and the lower part of the third-stage filter component are vertically engaged by inserting, to be assembled above and below the power charging copper bar, the power positive copper bar and the power negative copper bar.

9. The filter of the direct-current power supply according to claim 5, wherein
the first-stage filter component comprises an amorphous magnetic ring; and/or
the second-stage filter component comprises a ferrite magnetic ring; and/or
the third-stage filter component comprises a ferrite magnetic ring.

10. The filter of the direct-current power supply according to claim 1, wherein the filter further comprises:
a printed circuit board, covering a top of the base, wherein differential-mode components, common-mode components, and direct-current support capacitor components are disposed on a surface of the printed circuit board facing the base;
electrical connectors, respectively disposed on sides of the power charging copper bar, the power positive copper bar, and the power negative copper bar facing the printed circuit board, extending upward from tops of the power charging copper bar, the power positive copper bar, and the power negative copper bar, and electrically connected to the differential-mode components, the common-mode components, and the direct-current support capacitor components of the printed circuit board through vertical insertion.

11. The filter of the direct-current power supply according to claim 10, wherein the filter further comprises: a grounding copper bar;
wherein one end of each of the differential-mode components, the common-mode components, and the direct-current support capacitor components is connected to the grounding copper bar, and the grounding copper bar is connected to a ground terminal.

12. The filter of the direct-current power supply according to claim 10, wherein
each of the differential-mode components comprises at least one differential-mode capacitor, and each of the at least one differential-mode capacitor is connected between two of the power charging copper bar, the power positive copper bar, and the power negative copper bar; and/or
each of the common-mode components comprises at least two common-mode capacitors, and each of the common mode capacitors is connected between a ground terminal and one of the power positive copper bar, the power negative copper bar, and the power charging copper bar; and/or
the filter further comprises a current sensor disposed on the power positive copper bar.

13. The filter of the direct-current power supply according to claim 10, wherein
the direct-current power supply comprises a direct-current boost power supply;
the power positive copper bar is a positive copper busbar; and/or
the power negative copper bar is a negative copper busbar.

14. An electric drive controller, comprising the filter of the direct-current power supply according to any one of claims 1-13.

15. A vehicle, comprising the electric drive controller according to claim 14.
